## Europäisches Patentamt

## European Patent Office

## Office européen des brevets

(19)

(11) Veröffentlichungsnummer: **0 005 462**
**B1**

(12) **EUROPÄISCHE PATENTSCHRIFT**

(45) Veröffentlichungstag der Patentschrift:
**08.06.83**

(51) Int. Cl.³: **G 05 D 3/14,** G 03 B 41/00

(21) Anmeldenummer: **79101241.2**

(22) Anmeldetag: **24.04.79**

(54) **Verfahren zum Positionieren von zwei aufeinander einzujustierenden Objekten.**

(30) Priorität: **22.05.78 DE 2822269**
**24.10.78 DE 2846316**

(43) Veröffentlichungstag der Anmeldung:
**28.11.79 Patentblatt 79/24**

(45) Bekanntmachung des Hinweises auf die Patenterteilung:
**08.06.83 Patentblatt 83/23**

(84) Benannte Vertragsstaaten:
**CH FR GB NL**

(56) Entgegenhaltungen:
**NL-A-7 605 772**
**US-A-4 097 750**
**IBM TECHNICAL DISCLOSURE BULLETIN Vol. 15, Nr. 4, September 1972 New York B. EISENSTADT: «Semiconductor positioning system», Seiten 1363—1365.**

(73) Patentinhaber: **SIEMENS AKTIENGESELLSCHAFT, Berlin und München Wittelsbacherplatz 2, D-8000 München 2 (DE)**

(72) Erfinder: **Doemens, Günter, Dr., Föchingerstrasse 4, D-8150 Holzkirchen (DE)**

ACTORUM AG

Verfahren zum Positionieren von zwei aufeinander einzujustierenden Objekten

Die Erfindung betrifft ein Verfahren zum Positionieren von zwei aufeinander einzujustierenden Objekten, insbesondere zur Automatisierung der Maskenjustierung, um bei der Scheibenbelichtung in der Halbleiterfertigung die Struktur der Maske zur Struktur auf der Scheibe präzise zu justieren.

In der Halbleitertechnologie und in vielen anderen Anwendungsfällen, z. B. bei der Herstellung von strukturierten Platten für Skalen, steht man vor der Aufgabe, zwei strukturierte Platten mit hoher Genauigkeit zueinander auszurichten. Hierbei handelt es sich beispielsweise um zwei Substratplatten, von denen wenigstens eine transparent ist und die beide an einer Oberflächenseite ein Muster tragen.

In der Halbleitertechnologie muss im allgemeinen auf eine Halbleiterscheibe, die an ihrer Oberfläche bereits ein erstes Muster trägt und dort mit einem lichtempfindlichen Lack beschichtet ist, ein zweites in einer Maske enthaltenes Muster in einer zum ersten Muster genau justierten Lage übertragen werden.

Die Übertragung kann durch Kontaktbelichtung, Abstandsbelichtung oder Projektionsbelichtung erfolgen. Bei der Abstandsbelichtung, der zurzeit die grösste Bedeutung zukommt, besteht zwischen Maske und Scheibe zur Vermeidung von Maskenbeschädigungen ein Abstand von etwa 20 µm. Für die visuelle Justierung von Maskenstrukturen zu Scheibenstrukturen ist dies erschwerend, da nur eine Struktur scharf abgebildet werden kann, bzw. die Schärfenebene zwischen den beiden Strukturen liegt.

Normalerweise werden zur gegenseitigen Ausrichtung von Maske zu Scheibe spezielle Justiermarken mit zwei Justiermikroskopen verwendet, die in einem festen Abstand angeordnet sind.

In der DE-C-1919991 ist eine Anordnung beschrieben und dargestellt, bei der die automatische Ausrichtung von zwei mit Strukturen versehenen Platten zueinander mit nur drei oder sogar nur zwei Messsystemen möglich ist.

Aus der NL-A-7605772 ist es bekannt, die Positionierung eines Justierstriches dadurch durchzuführen, dass ein optoelektronisches Signal differenziert wird. Zur Bestimmung der Lage des Justierstrichs wird das Maximum der Differenzkurve benutzt.

Der Erfindung liegt die Aufgabe zugrunde, bei geringsten optischen Kontrasten und unscharfer Abbildung der Strukturen auf der Maske zu den Strukturen auf der Scheibe mit hoher Genauigkeit vollautomatisch in kurzer Zeit zu justieren. Ausserdem soll das Verfahren mit möglichst geringem apparativem Aufwand realisierbar sein und das Justierergebnis von Schwankungen der optischen Eigenschaften der Strukturen sowie von Störungen in deren Verlauf weitgehend unbeeinflusst sein.

Diese Aufgabe wird dadurch gelöst, dass anhand von verschiedenen orthogonal zueinander verlaufenden geraden Strichen auf der Scheibe und auf der Maske mittels dazu jeweils parallel verlaufender, zeilenweiser opto-elektronischer Abtastung die Intensität der Helligkeitswerte zeilenweise oder zeilenabschnittsweise integriert wird, dass die daraus resultierenden Werte gespeichert und die Differenz aus dem Integrationsergebnis von aufeinanderfolgenden Zeilen gebildet und dass aus dem dabei entstehenden örtlichen Verlauf der Differenzwerte, die aufgrund der Helligkeitsänderung entsanden sind, in den Bereichen unterhalb der Differenzwertkurven Flächenschwerpunkte gebildet werden, und dass die so erhaltenen Lagen der verschiedenen Flächenschwerpunkte weiter zu einem ersten Mittelwert zusammengefasst werden, der dem Strichrand entspricht und gegebenenfalls die ersten Mittelwerte zu einem zweiten Mittelwert zusammengefasst werden, der der Lage der Mittelachse eines Striches auf der Scheibe bzw. Maske zuzuordnen ist und dass dieser Vorgang für beide der orthogonalen Richtungen (x, y) der Justierstrukturen auf Maske und Scheibe durchgeführt wird.

Durch die Integration kann man sehr geringe Kontraste beherrschen, die sogar unter der Rauschamplitude eines Bildwandlers liegen. Durch die zeilenweise Differenzbildung wird man weitgehend unabhängig von Beleuchtungs- und Empfängerinhomogenitäten. Die Flächenschwerpunktsbildung macht die Ergebnisse ebenfalls weitgehend unabhängig von Schwankungen der Beleuchtungsintensität und den Reflektionseigenschaften der Oberfläche. Anstelle der Flächenschwerpunktsbildung kann auch die Erfassung der Maximalwerte aus dem Differenzsignal herangezogen werden. Durch die Mittelwertbildung aus verschiedenen Schwerelinien bzw. der Lage der verschiedenen Maxima erreicht man wesentlich höhere Genauigkeit als sie durch die systematische Auflösung des Zeilenabstandes gegeben ist. Durch die grosse Integrationslänge werden Störungen, wie Einbuchtungen in Kanten oder isolierte Punkte, unterdrückt, sofern deren Grösse klein im Verhältnis zur Integrationslänge ist, oder deren Kantenorientierung deutlich von den Zeilenrichtungen abweichen, was in der Regel zutrifft.

Nach einer Weiterbildung der Erfindung erfolgt das Verfahren in mindestens zwei Schritten, und zwar einer Grobjustierung und einer Feinjustierung, und dass zur Grobjustierung im Randbereich des Gesichtsfeldes der Abtastvorrichtung zeilenweise zur Erfassung der Striche auf der Scheibe integriert wird und dass dann die Scheibe bzw. Maske verfahren und zur Feinjustierung in einem anderen Integrationsbereich, z. B. in der Mitte des Gesichtsfeldes der Abtastvorrichtung, die Lage der dann schon eng benachbarten Justierstriche von Maske und Scheibe zueinander ermittelt wird.

Durch die zwei- oder mehrstufige Justierung wird erreicht, dass die Justiermarken von Maske und Scheibe beim letzten Justierschritt auch bei einem grossen anfänglichen Einfangbereich sehr nahe beieinander liegen und dadurch Verzeichnungsfehler, die entweder aus der Optik oder dem Bildwandler resultieren können, kaum mehr in das Messergebnis eingehen.

Nach einer weiteren Ausgestaltung der Erfindung liegen zur Erzielung einer hohen Genauigkeit bei der Feinjustierung die Justierlinien der Scheibe zwischen denen der Maske bzw. umgekehrt, z. B. Scheibenstrich-Maskenstrich-Scheibenstrich oder umgekehrt, so dass eine Symmetriebetrachtung durchgeführt werden kann. Der Vorteil der Symmetriebetrachtung liegt darin, dass die Justierung nicht mit absoluten Werten durchgeführt werden muss, so dass eventuell geringfügige Eichfehler der Anlage kaum in das Justierergebnis eingehen.

Zur vollen Ausnützung der Leistungsfähigkeit von besonders genauen Strukturübertragungsverfahren für kleinste Strukturen, wie beispielsweise Projektionsbelichtung und Röntgenlithographie, ist die visuelle Justiergenauigkeit häufig nicht mehr ausreichend. Durch die Erfindung soll in Weiterbildung des offenbarten Gedankens ein vollautomatischer Justierablauf gewährleistet werden, dessen Genauigkeit den Anforderungen, z. B. auch der eben angegebenen Verfahren, entspricht.

Die Lösung besteht darin, dass die Abtastung durch eine Mehrfachanordnung analoger optoelektronischer Einzelanordnungen mit paralleler Informationsverarbeitung vorgenommen wird, die jeweils analoge Integrationsbereiche erfassen, wobei jeweils die Symmetriebetrachtung innerhalb einer Einzelanordnung durchgeführt wird und die Einzelergebnisse zu einem Endergebnis zusammengefasst werden. Bei der Lösung nach der Erfindung wird dabei die Genauigkeit entsprechend den statistischen Gesetzen erhöht und nimmt mit der Zahl der Einzelelemente zu. Ferner wird durch die Mehrfachanordnung der Einfluss von sich ändernden Kantenausbildungen insbesondere auf der Scheibe von der Justiergenauigkeit weitgehend eliminiert.

Zur Erhöhung der Sicherheit können die zur Auswertung herangezogenen Flächenschwerpunkte bezüglich ihrer Anzahl, Form und Verteilung überwacht werden.

Für die Lageerkennung bei der Grobjustierung kann die Integration vorzugsweise in den äusseren Bereichen des Gesichtsfeldes eines zeilenweise arbeitenden Bildwandlers durchgeführt werden, während die Justierstruktur für die Feinjustierung ausserhalb dieses Bereiches vorzugsweise in der Mitte des Gesichtsfeldes liegt. Auf diese Weise entsteht eine eindeutige Unterscheidungsmöglichkeit zwischen Linien auf der Maske und der Scheibe. Ferner wird dadurch gewährleistet, dass die Feinjustierung im Bereich der otpischen Achse vorgenommen wird.

Die zeilenweise Integration der Helligkeitswerte wird analog über Operationsverstärker durchgeführt, ferner die Differenzbildung der aufeinanderfolgenden Integrale ebenfalls analog realisiert und dann die je Zeile vorliegenden Spannungswerte analog/digital gewandelt und in einer Recheneinheit, vorzugsweise in einem Mikroprozessor, gespeichert werden und dort die Flächenschwerpunktsbestimmung, die Zusammenfassung mehrerer Flächenschwerpunkte zu Mittelwerten und daraus die Stellgrössen für den Justiervorgang ermittelt und ausgegeben werden. Durch die analoge Bildvorverarbeitung (Integration und Differenzbildung) entsteht kein Informationsverlust des Bildinhalts. Ausserdem läuft diese Verarbeitung in Echtzeit ab und trägt wesentlich dazu bei, dass die gesamte Bildauswertung in relativ kurzer Zeit durchgeführt werden kann.

Weitere Einzelheiten der Erfindung ergeben sich aus den Patentansprüchen.

Ein Weg zur Ausführung der Erfindung wird anhand der Figuren erläutert. Es zeigen:

Fig. 1 ein Prinzip der Erkennung kontrastarmer Kanten;

Fig. 2 ein Prinzip der Erfassung von Linien auf der Scheibe bzw. Maske;

Fig. 3 die Anordnung der Justierstrukturen auf Maske und Scheibe mit verschiedenen Auswertebereichen grob/fein;

Fig. 4 Aufbauvarianten;

Fig. 5a bis 5g im Prinzip die Einzelanordnung Scheibenstrich-Maskenstrich-Scheibenstrich mit den entsprechenden Auswertungen;

Fig. 6 eine Mehrfachanordnung in Form eines zweidimensionalen Gitters;

Fig. 7 das zweidimensionale Gitter auf Maske und Scheibe zentrisch in einem Gesichtsfeld;

Fig. 8 ein Matrixfeld der Einzelergebnisse und ebenfalls ein Matrixfeld mit möglichen Gewichtungsfaktoren und

Fig. 9 wiederum das zweidimensionale Gitter mit den Integrationsbereichen sowie eine Anordnung von parallelen Prozessoren.

Mit dem Auge können kontrastarme Kanten noch durchaus gut wahrgenommen werden, obwohl sie im Signal eines Bildwandlers, z. B. einer Fernsehkamera, in Kontrasthub unter der Rauschamplitude liegen. Eine elektronische Erkennung wird dadurch äusserst erschwert.

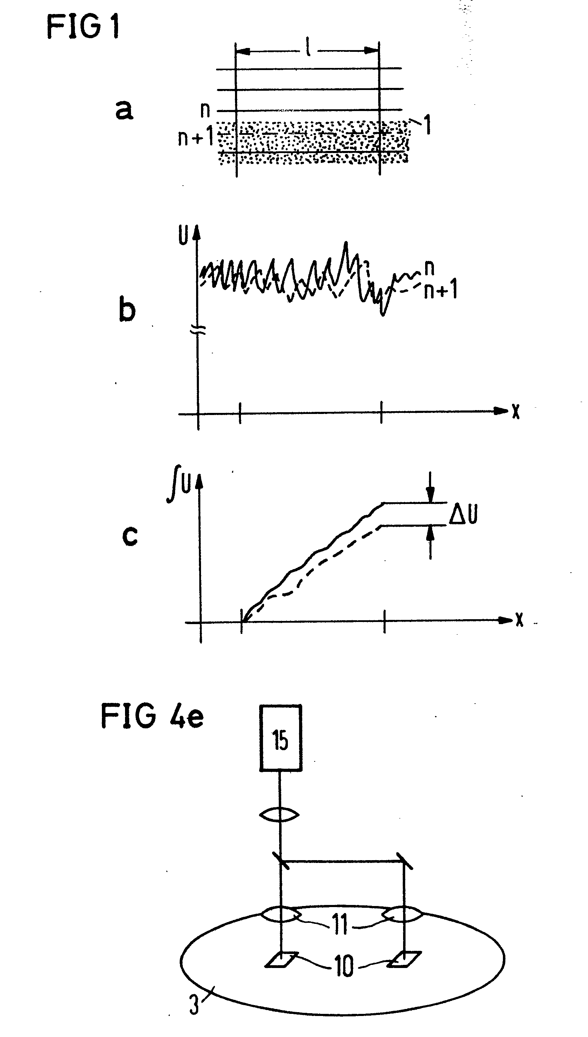

Die Fig. 1 zeigt, wie dieser Nachteil für geradlinige Kanten mit annähernd bekannter Winkelorientierung behoben werden kann. Dazu wird ein zeilenförmig arbeitender Bildwandler (z. B. TV-Kamera, Laser, Scanner, Halbleiterbildwandler) in seiner Zeilenrichtung etwa parallel zur gesuchten Kante orientiert und über eine gewisse Strecke 1 das Videosignal integriert.

In Fig. 1a ist eine kontrastarme Kante 1, die Lage der Zeilen n, n+1 und die Integrationslänge 1 dargestellt.

Aus 1b ist der Spannungsverlauf innerhalb der Zeilen n und n+1 ersichtlich, wobei die Zeile n vor der gesuchten Kante und die Zeile n+1 in der gesuchten Kante liegt. Der Kontrasthub ist hier geringer als die Rauschamplitude und dadurch die Kante nicht unmittelbar elektronisch erfassbar. Fig. 1c zeigt das Ergebnis einer Integration über die Länge 1 für die Zeilen n und n+1. Diese Integration liefert einen eindeutigen wiederholbaren Spannungsunterschied ΔU, der zur sicheren elektronischen Kantenerkennung ausreichend ist.

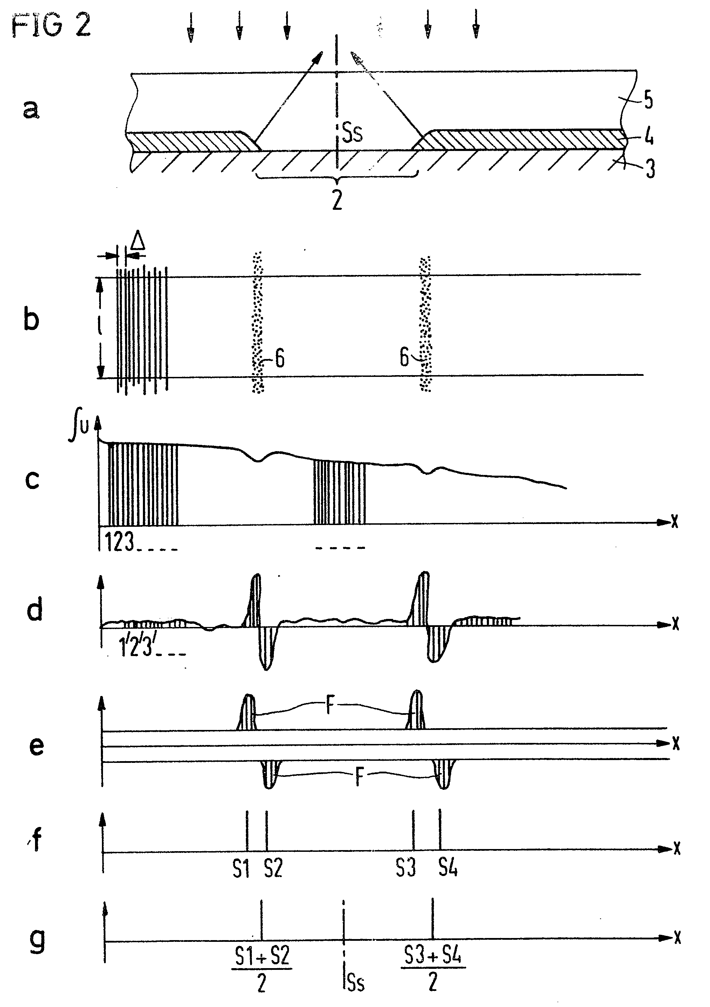

Die Fig. 2 zeigt das prinzipielle Verfahren zur Erkennung und Lagebestimmung der Linien auf Maske (z. B. Chromstruktur) bzw. Scheibe (z. B. Oxidstruktur). Anhand einer Linie 2 auf einer Scheibe 3, die durch eine Oxidschicht 4 gebildet ist und mit Fotolack 5 abgedeckt ist, wird demonstriert. Optisch erscheinen Linien dieser Art in der Regel aufgrund ihrer Böschungen an den Rändern, die paralleles Auflicht nicht in das abbildende Objektiv zurückreflektieren. In diesem Fall ergeben sich aus der Begrenzung für die Linie 2 zwei dunkle kontrastarme Striche 6 (Fig. 2b). Links in dieser Darstellung ist die Abtastrichtung angedeutet. Sie läuft parallel zur gesuchten Linie 2 bzw. 6. Der Abstand zwischen zwei Zeilen ist mit Δ und die Länge für die analoge Integration mit 1 bezeichnet.

Das Ergebnis der analogen Integration zeigt die Fig. 2c. Die kontrastschwachen Striche 6 erscheinen in diesem Signal nur als schwache Einbuchtungen. Die unsymmetrische Gesamtverteilung soll eine nicht vollkommen homogene Beleuchtung bzw. eine Empfängerinhomogenität darstellen. Die fortlaufenden Fernsehzeilen haben in diesem Verarbeitungsstadium die fortlaufenden Nummern 1, 2, 3 und so weiter.

Das Bild 2d zeigt die zeilenweise Differenz aus dem Signal 2c.

Zur Verbesserung des Signals 2d kann auch anstatt der Differenz der benachbarten Zeilen die Differenz von Zeilen mit einem bestimmten Abstand gebildet werden, z. B. die Zeilen 1 minus 3, Zeilen 2 minus 4 usw. Ferner ist es zweckmässig, an dieser Stelle aus Zeitgründen eine Glättung des Kurvenverlaufs mit schaltungstechnischen Mitteln vorzunehmen. Die Fernsehzeilen haben in diesem Verarbeitungsstadium (Differenzsignal) die fortlaufenden Nummern 1', 2', 3' usw. Ein Weg hierzu bestünde beispielsweise darin, das Differenzsignal über mehrere Zeilen zusammenzufassen und ineinanderzufügen, wie beispielsweise durch die Operation 1'+2'+3'; 2'+3'+4'; 3'+4'+5' usw. angedeutet ist.

Als nächster Schritt wird das so vorliegende und vorverdichtete analoge Bildsignal zeilenweise digitalisiert und in einer Recheneinheit, z. B. einem Mikroprozessor, gespeichert. Wie im Bild 2e dargestellt, wird das Signal in den Bereich der Nullinie durch eine symmetrische Schwelle abgetrennt. Es entstehen dadurch für jeden Hell- und Dunkelübergang eine isolierte Fläche F, die die Änderung der Helligkeitsintegrale in den jeweiligen Bereichen darstellt.

Zur Lagebestimmung der Linie 2 werden nun die Flächenschwerpunkte der einzelnen Linien im Rechner bestimmt. Die Flächenschwerpunktsbildung hat im Vergleich zu einer festen Bewertungsschwelle den Vorteil, dass die Ergebnisse unabhängig von der Höhe des Kontrastes und von dessen Schärfe sind. Ferner wird die Lagebestimmung nicht oder nur unwesentlich von ungleichmässig stark ausgeprägten Strichen innerhalb einer Linie beeinflusst.

Die Ergebnisse der Flächenschwerlinienbestimmung sind in Fig. 2f dargestellt. In diesem Fall handelt es sich um vier Zeilennummern und zwar S1 bis S4. Weitere Mittelwertbildungen aus diesen Werten schliessen sich an. Zunächst wird der Mittelwert zwischen S1 und S2 bzw. S3 und S4 gebildet (Fig. 2g) und daraus wiederum die Mittelachse errechnet (Fig. 2g), die die körperliche Achse Ss der gesuchten Linie 2 darstellt.

Durch die Flächenbestimmung sowie durch die wiederholte Mittelwertbildung werden Genauigkeiten erzielt, die weit grösser sind als die durch den Zeilenabstand vorgegebene systematische Auflösung.

Eine Verstärkung dieses Effekts kann dadurch erreicht werden, dass man die Justierlinien so gestaltet, dass mehr als zwei dunkle Striche pro Linie entstehen.

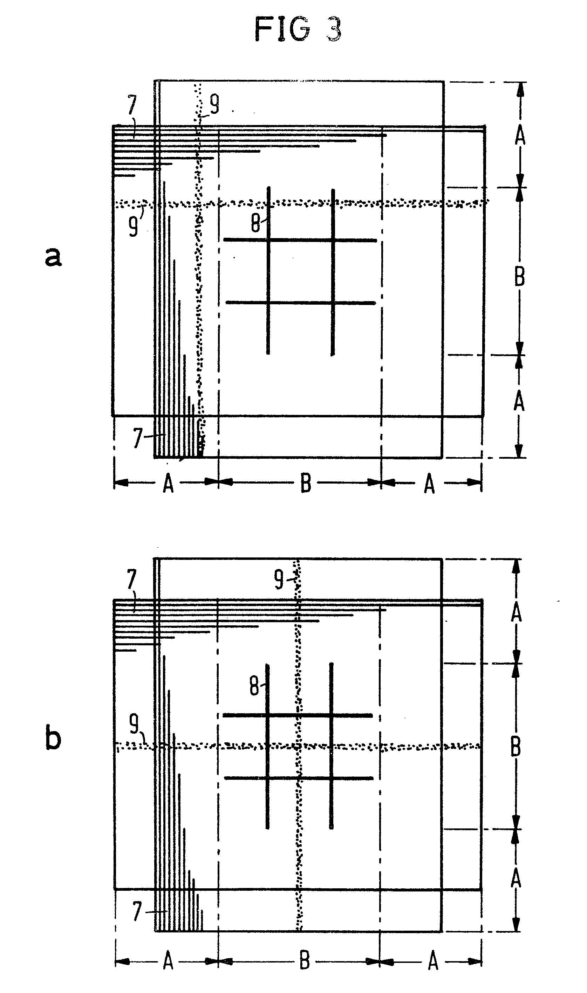

In der Fig. 3 ist eine mögliche Justierstruktur mit den entsprechenden Auswertebereichen dargestellt für den Fall, dass beim Justiervorgang die Scheibe zur Maske verfahren wird. Fig. 3a zeigt das Raster 7 zweier zeilenweise arbeitenden Bildwandler, deren Abtastrichtung senkrecht zueinander angeordnet sind, in dessen Mitte sich die Justierstruktur 8 auf der Maske befindet. Die Justierstruktur auf der Maske stellt ein Quadrat oder ein quadratähnliches Gebilde dar. Die Justierstruktur auf der Scheibe 9 ist ein Kreuz, das auch aus mehreren Linien bestehen kann. Für die grobe Lageerkennung dieses Kreuzes wird nun in den Randbereichen A des Rasters zeilenweise integriert und die Lage der Linien nach Fig. 2 bestimmt. Durch diese Anordnung von Maske und Scheibe wird gewährleistet, dass innerhalb der Integrationsbereiche A sich nur Justierstrukturen der Scheibe befinden können.

Als nächster Schritt wird die Scheibe entsprechend der ermittelten Ablage ins Zentrum des Rasterfeldes zwischen die beiden parallelen Justiermasken der Maske gefahren (Fig. 3b). Zur Feinjustierung erfolgt nun eine zeilenweise Integration im Bereich B des Rasterfeldes und eine Auswertung dieses Signals zur Lagebestimmung von Justierstruktur auf Maske und Scheibe nach dem Verfahren in der Fig. 2. Die Unterscheidung zwischen Strukturen auf Maske und Scheibe ist durch deren zwangsläufig örtliche Reihenfolge möglich. Es sind drei Bereiche eindeutig definierbar, in denen nur Masken bzw. Scheibenstrukturen vorhanden sein können. Da die Kontraste auf der Maske im allgemeinen sehr deutlich und konstant sind, während diese Verhältnisse auf der Scheibe starken Schwankungen unterworfen sind, wird zweckmässigerweise in den drei Bereichen für Maskensignale und Scheibensignale eine unterschiedliche Verstärkung im Differenzsignal vorgenommen, um annähernd gleiche Amplituden zu bekommen. Dies kann automatisch durch eine elektronische Bestimmung des maximalen Wertes des Differenzsignals im Scheibenbereich in Verbindung mit einer anschliessenden Nachführung der Verstärkung erfolgen.

Aus der nach Fig. 2 ermittelten Lage der Schwerelinien auf Scheibe und Maske werden durch entsprechende weitere Mittelwertbildungen und symmetrische Betrachtungen die Positionsabweichungen von Scheibe zu Maske für die Feinjustierung bestimmt.

Für die Position senkrecht dazu werden entweder das Bild gedreht oder eine orthogonal dazu erzeugte Abtastrichtung, z. B. durch eine zweite Fernsehkamera, verwendet. Der Ablauf ist entsprechend.

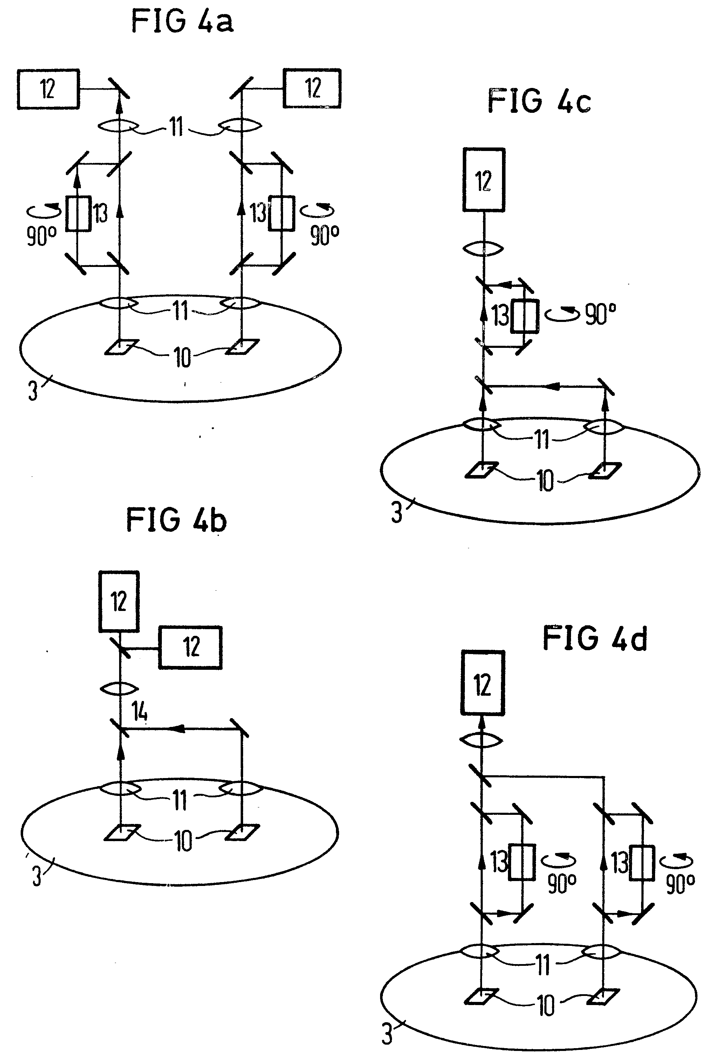

Für den Aufbau und die Anordnung bezüglich Optik, Mechanik und Bildwandler ergeben sich für die Erzeugung der senkrecht zueinander liegenden Abtastraster und den beiden für die Maskenjustierung erforderlichen Gesichtsfeldern prinzipiell folgende Möglichkeiten (Fig. 4): Auf der Scheibe 3 befinden sich die zwei Gesichtsfelder 10 mit den entsprechenden Justiermarken. Diese werden über Objektive 11 auf zwei Fernsehkameras 12 abgebildet. Die Bilddrehung erfolgt dadurch, dass der jeweilige Strahl aufgeteilt und über Drehprismen 13 um 90° gedreht und dann wieder in den ursprünglichen Strahleingang eingespiegelt wird. Die Ein- und Ausblendung erfolgt elektromechanisch über Schwenkblenden (nicht gezeichnet).

Eine optische Bilddrehung wird in Fig. 4b vermieden. Hier werden die beiden optischen Kanäle der zwei Gesichtsfelder in einem Kanal 14 zusammengefasst und dann wieder auf zwei Fernsehkameras aufgeteilt, deren Abtastrichtung senkrecht zueinander angeordnet ist. Die jeweiligen Kanäle werden ebenfalls elektromechanisch ein- und ausgeblendet.

Es genügt auch ein Bildwandler (Fig. 4c), wenn man die Bilddrehung optisch durchführt und die beiden Kanäle auch optisch zusammenfasst. Die Bilddreheinrichtung kann entweder in dem zusammengefassten Stellengang erfolgen (Fig. 4c) oder davor für jeden einzelnen Kanal (Fig. 4d).

Statt Fernsehkameras kann auch eine entsprechende Halbleiterbildkamera verwendet werden.

Bei der Verwendung eines Bildwandlers mit frei wählbarer Abtastrichtung 15 ergibt sich eine Anordnung nach Fig. 4e, die optische Bilddrehung entfällt, ein Bildwandler ist ausreichend.

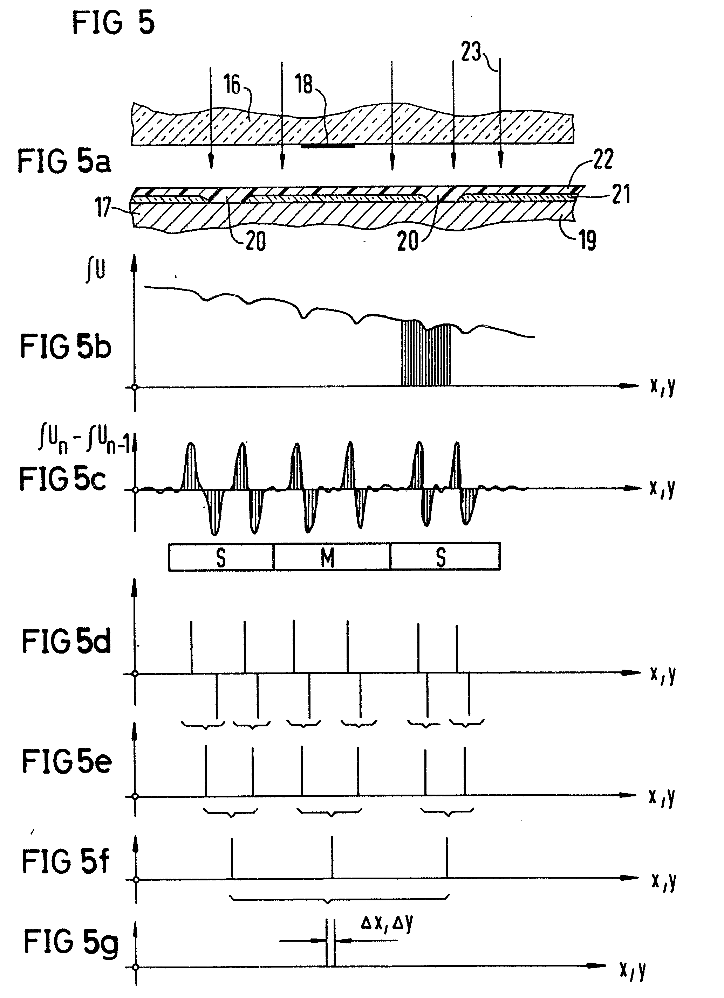

In der Fig. 5a ist mit 16 eine Maske bezeichnet, die auf der einer Scheibe 17 zugewandten Seite einen Chromstrich 18 aufweist. Die Scheibe 17, die in einem gewissen Abstand angeordnet sein kann, besteht z. B. aus Silizium 19, worauf zwei Striche 20 sich befinden, die aus Aussparungen von Siliziumoxid 21 herrühren können. Darüber befindet sich die Strukturübertragung einer Fotolackschicht 22. Bei paralleler Auflichtbeleuchtung 23 erscheinen die Striche auf der Scheibe als dunkle Doppellinien aufgrund des an der Böschung aus dem abbildenden Objektiv heraus reflektierten Lichts.

Die Fig. 5b zeigt die Ergebnisse der zeilenweisen Integration über dem Ort der Anordnung Maske-Scheibe, wobei die Einbuchtungen im Linienzug den dunklen Linien zuzuordnen sind, die von den Böschungen bzw. von dem Chromstrich hervorgerufen werden.

Die Fig. 5c zeigt die Differenzbildung der Integrationswerte benachbarter Zeilen sowie die eindeutige Zuordnung zu den Bereichen Scheibe S, Maske M und Scheibe S.

Nach einer Digitalisierung der Amplitudenwerte im Signalverlauf der Fig. 5c erfolgt die Errechnung der jeweiligen Spitzenmaxima bzw. Flächenschwerpunkte. Daraus ergeben sich Lagekoordinaten in Richtung x bzw. y (Fig. 5d). Diese werden nun weiter zusammengefasst, wie Fig. 5e zeigt und nach einer Symmetriebetrachtung (Fig. 5f) das Endergebnis $\Delta x$ bzw. $\Delta y$ (Fig. 5g) ermittelt.

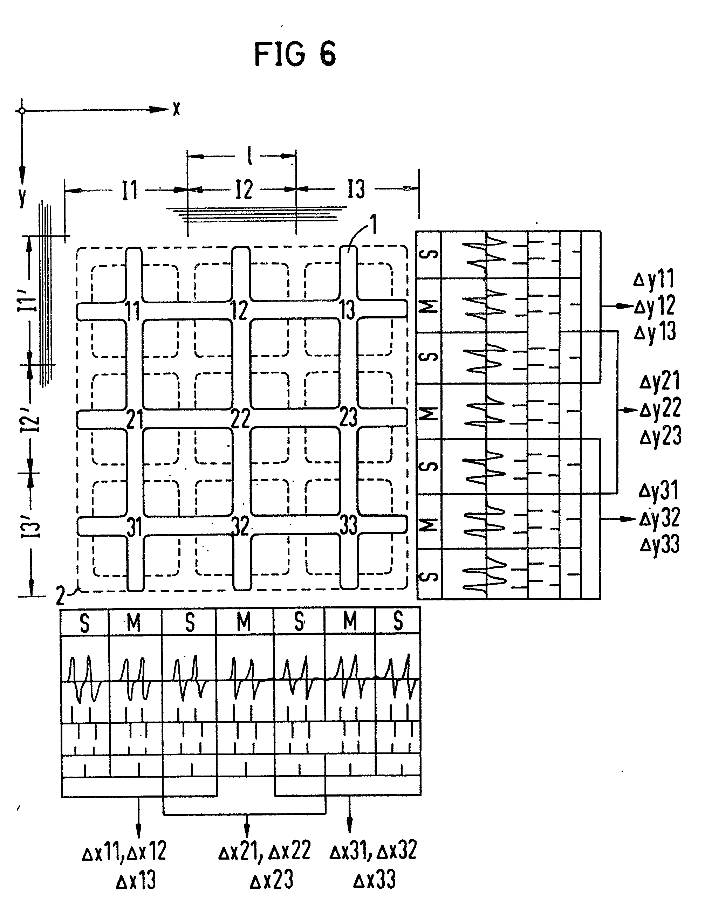

Die Fig. 6 zeigt die Mehrfachanordnung in Form eines zweidimensionalen Gitters mit den entsprechenden parallelen Integrationsbereichen, sowie die Auswertung für die verschiedenen Einzelanordnungen. In dieser Figur sind mit 1 die Breite eines Integrationsbereiches und mit l1 bis l3 bzw. l1' bis l3' Einzelintegrationsbereiche gekennzeichnet. Die Bezugszeichen $\Delta y11...\Delta y33$ kennzeichnen die einzelnen Ergebnisse in der y-Richtung und $\Delta x11...\Delta x33$ die Ergebnisse in der x-Richtung.

Bei der Lösung nach der Erfindung wird entsprechend der Zahl der Gitterelemente in drei Spalten in x- und y-Richtung integriert. Dadurch entstehen neue Gitterelemente mit jeweils neun Wertepaaren $\Delta x_m$, $\Delta y_m$. Der Mittelwert hierauf liefert dann die endgültige Ablage $\Delta x$ und $\Delta y$.

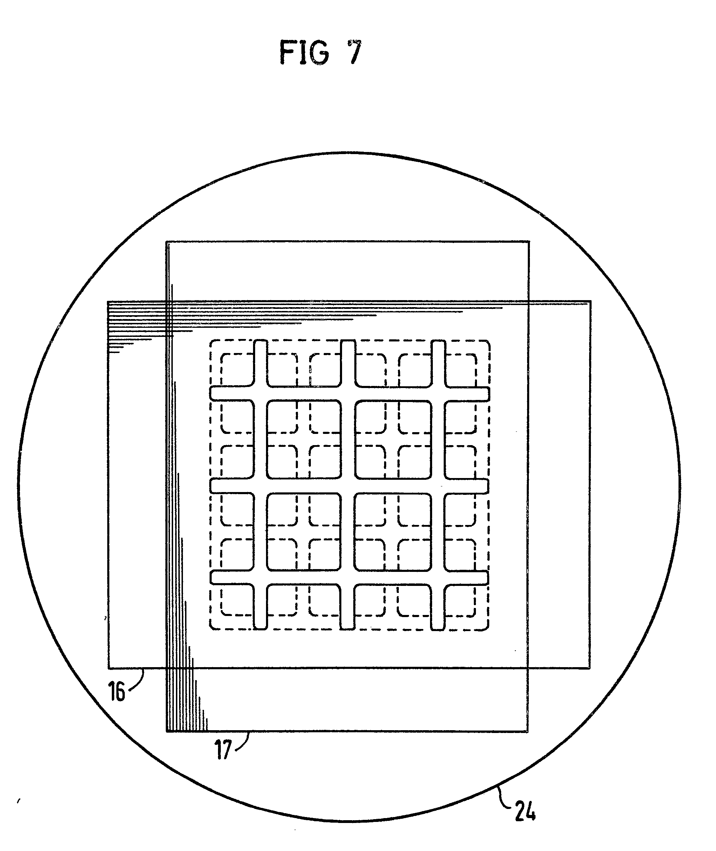

Die Fig. 7 zeigt das zweidimensionale Gitter auf Maske 16 und Scheibe 17 zentrisch in einem Gesichtsfeld 24 der abbildenden Optik, sowie für die Realisierung der parallelen und orthogonalen Integrationsbereiche zwei orthogonal angeordnete zeilenweise organisierte Abtastfelder von zwei elektronischen Bildwandlern, z. B. TV-Kameras.

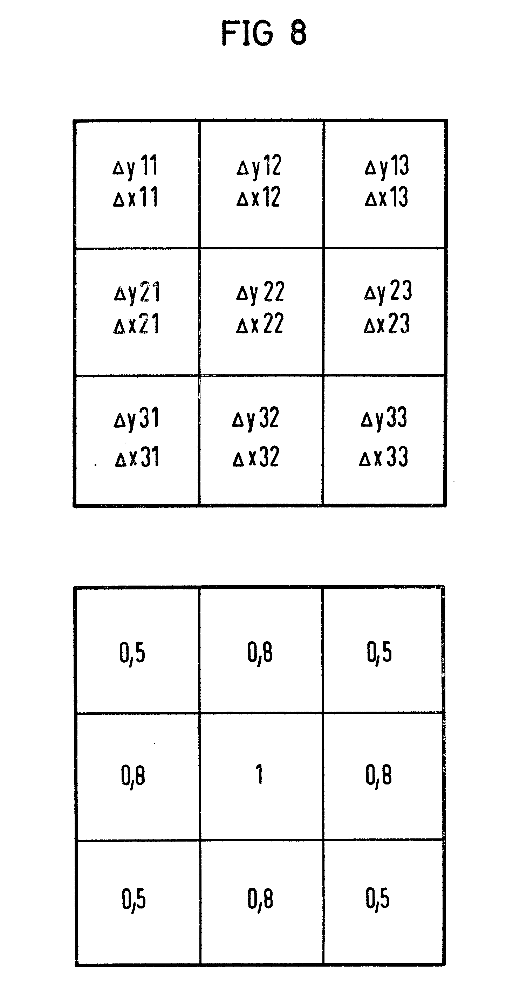

Bei der Darstellung in der Fig. 8 wurde als Einzelkriterium der Abstand von der optischen Achse der Einzelanordnung herangezogen. Bei der Mittelwertbildung kann nämlich zur Steigerung der Gesamtgenauigkeit noch eine Gewichtung der Ergebnisse $\Delta x_m$, $\Delta y_n$ aus den einzelnen Gitterelementen derart erfolgen, dass die Ergebnisse aus den Elementen, die von der optischen Achse weiter entfernt sind, geringer gewichtet werden. Durch die Verschiebung der Gitter auf Maske und Scheibe ineinander und infolge der zunächst auf die einzelnen Gitterelemente bezogenen Auswertung für $\Delta x_m$, $\Delta x_n$ ist die Genauigkeit, mit der eine einzelne Linie erfasst wird, nur auf den kleinen Bereich eines Gitterelementes zu beziehen. Die erzielbare Gesamtgenauigkeit ergibt sich aus der Genauigkeit der Einzellinien in Verbindung mit der Zahl der Linien je Gitterelement und der Anzahl der Gitterelemente nach den statistischen Gesetzen.

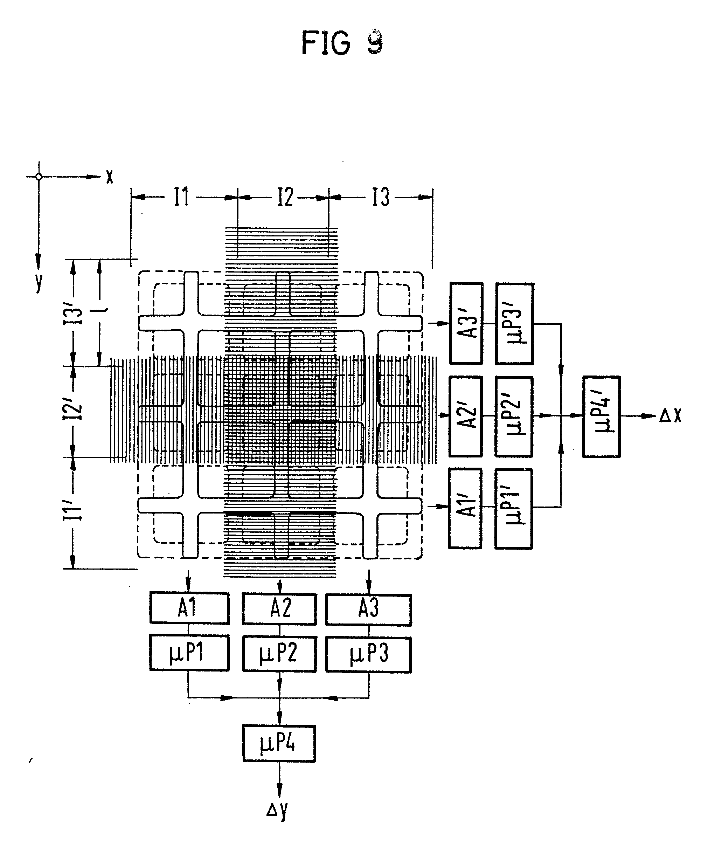

Fig. 9 zeigt wiederum das zweidimensionale Gitter mit den Integrationsbereichen l bzw. l', sowie eine Anordnung von Parallel-Prozessoren $\mu P1$ bis $\mu P3$ bzw. $\mu P1'$ bis $\mu P3'$ sowie die Prozessoren $\mu P4'$ und $\mu P4$ zur Zusammenfassung bzw. Mittelwertbildung der Einzelergebnisse in x- und y-Richtung.

Für die Realisierung der in der Fig. 6 gezeigten Auswerteverfahren bietet sich bei der Matrix-Struktur für die Berechnung der $\Delta x_m$, $\Delta y_n$ in den einzelnen Elementen der Einsatz von Parallel-Pro-

zessoren µP an, denen jeweils ein Analogteil für die zeilenweise Integration und Differenzbildung zugeordnet ist. Weitere Mikroprozessoren übernehmen die Mittelwertbildung der Ergebnisse aus den einzelnen Gitterelementen.

Um eine möglichst kurze Justierzeit zu erreichen, zeigt Fig. 9 eine möglichst parallele Bildverarbeitung des zweidimensionalen Gitters. Dabei ist für jede Spalte in x- und y-Richtung jeweils eine analoge Auswerteeinrichtung (A1 bis A3 bzw. A1' bis A3') vorgesehen, durch die die Integration und die Differenzbildung vorgenommen wird. Für die weitere digitalisierte Verarbeitung (Flächenschwerpunktbildung, Mittelwertbildung, Zusammenfassung und Symmetriebetrachtung) nach Fig. 1 ist wiederum für jede Spalte in x- und y-Richtung ein Mikroprozessor (µP1 bis µP3 bzw. µP1' bis µP3') vorgesehen. Die Zusammenfassung der Einzelergebnisse aus den Einzelanordnungen in x- und y-Richtung wird durch die Prozessoren µP4 bzw. µP4' durchgeführt.

Die Pfeile in Richtung Δx und Δy deuten die Ausgabe des Ergebnisses der Lageerkennung zu den Stellelementen an.

Zur Steigerung der Genauigkeit bietet sich bei der hier vorliegenden schnellen parallelen Informationsverarbeitung eine Mehrfachwiederholung des Messdurchlaufes und eine Mittelwertbildung aus den Einzelergebnissen (Δx, Δy) an.

**Patentansprüche**

1. Verfahren zum Positionieren von zwei aufeinander einzujustierenden Objekten, insbesondere zur Automatisierung der Maskenjustierung, um bei der Scheibenbelichtung in der Halbleiterfertigung die Struktur der Maske zur Struktur auf der Scheibe präzise zu justieren, dadurch gekennzeichnet, dass anhand von verschiedenen orthogonal zueinander verlaufenden geraden Strichen (9, 20 bzw. 8, 18) auf der Scheibe (3, 17) und auf der Maske (16) mittels dazu jeweils parallel verlaufender zeilenweiser (7) opto-elektronischer Abtastung (12, 15) die Intensität der Helligkeitswerte zeilenweise oder zeilenabschnittsweise integriert wird (Fig. 2c, 5b) dass die daraus resultierenden Werte gespeichert und die Differenz aus dem Integrationsergebnis von aufeinanderfolgenden Zeilen gebildet (Fig. 2d, 2e, 5c) und dass aus dem dabei entstehenden örtlichen Verlauf der Differenzwerte, die aufgrund der Helligkeitsänderung entstanden sind, in den Bereichen unterhalb der Differenzwertkurven Flächenschwerpunkte gebildet werden, und dass die so erhaltenen Lagen der verschiedenen Flächenschwerpunkte weiter zu einem ersten Mittelwert zusammengefasst werden, der dem Strichrand entspricht (Fig. 2g, 5e) und gegebenenfalls die ersten Mittelwerte zu einem zweiten Mittelwert zusammengefasst werden, der der Lage der Mittelachse eines Striches auf der Scheibe bzw. Maske zuzuordnen ist (Fig. 5f) und dass dieser Vorgang für beide der orthogonalen Richtungen (x, y) der Justierstrukturen auf Maske und Scheibe durchgefürt wird.

2. Verfahren nach Anspruch 1, dadurch gekennzeichnet, dass das Verfahren in mindestens zwei Schritten, und zwar einer Grobjustierung und einer Feinjustierung erfolgt, und dass zur Grobjustierung im Randbereich des Gesichtsfeldes (10) der Abtastvorrichtung zeilenweise zur Erfassung der Striche auf der Scheibe integriert wird und dass dann die Scheibe bzw. Maske verfahren und zur Feinjustierung in einem anderen Integrationsbereich, z. B. in der Mitte des Gesichtsfeldes der Abtastvorrichtung, die Lage der dann schon eng benachbarten Justierstriche von Maske und Scheibe zueinander ermittelt wird.

3. Verfahren nach Anspruch 2, dadurch gekennzeichnet, dass zur Erzielung einer hohen Genauigkeit bei der Feinjustierung die Justierlinien (9) der Scheibe zwischen denen (8) der Maske liegen bzw. umgekehrt, so dass eine Symmetriebetrachtung durchgeführt werden kann (Fig. 3a, b).

4. Verfahren nach Anspruch 3, dadurch gekennzeichnet, dass die Abtastung durch eine Mehrfachanordnung analoger opto-elektronischer Einzelanordnungen mit paralleler Informationsverarbeitung vorgenommen wird, die jeweils analoge Integrationsbereiche erfassen, wobei jeweils die Symmetriebetrachtung innerhalb einer Einzelanordnung durchgeführt wird und die Einzelergebnisse zu einem Endergebnis zusammengefasst werden (Fig. 6).

5. Verfahren nach Anspruch 4, dadurch gekennzeichnet, dass jeder Einzelanordnung ein Integrationsbereich zugeordnet ist, der je einen Strich auf der Maske, auf der Scheibe, und wieder auf der Maske oder umgekehrt enthält, wobei die Integrationsrichtung parallel zu den jeweiligen Strichen verläuft und die Integrationslänge der Länge der Linien innerhalb des Gesichtsfeldes der Einzelanordnung entspricht (Fig. 6).

6. Verfahren nach den Ansprüchen 4 und 5, dadurch gekennzeichnet, dass bei der Mittelwertbildung eine Gewichtung der Ergebnisse derart erfolgt, dass den Einzelergebnissen aus Bereichen mit einer geringer erwarteten Messunsicherheit höhere Werte beigemessen werden, z. B. einer zweidimensionalen Gitteranordnung der Mitte, die der optischen Achse am nächsten liegt, ein höheres Gewicht beigemessen wird als den Ergebnissen aus den Einzelanordnungen, die von der optischen Achse weiter entfernt sind (Fig. 8).

7. Vorrichtung zur Durchführung des Verfahrens nach einem der Ansprüche 1 bis 3, dadurch gekennzeichnet, dass für jeden Justierbereich eine Optik mit Beleuchtung (23) vorgesehen ist, die den Bereich von Maske (16) und Scheibe (17), der mit Justierstrukturen versehen ist, auf einen zeilenförmig abtastenden Bildwandler (12) abbildet.

8. Vorrichtung nach Anspruch 7, dadurch gekennzeichnet, dass zur Erzielung von orthogonal aufeinander stehenden Abtastrichtungen zwei entsprechend angeordnete Fernsehkameras (12) oder Festkörperbildwandler vorhanden sind, bzw. dass Bildwandler (15) mit frei wählbarer Abtastrichtung, wie beispielsweise eine Image-dissection-Röhre, Verwendung findet oder dass das optische Bild durch eine entsprechende Anordnung (13) gedreht wird und auf einem Bildwandler mit fester Abtastrichtung abgebildet wird.

9. Vorrichtung nach Anspruch 7 oder 8, dadurch gekennzeichnet, dass auf der Scheibe als Justierstruktur vorzugsweise ein Kreuz (9) verwendet wird, das auch aus mehreren Linien bestehen kann und dessen Länge etwa dem Gesichtsfeld des Bildwandlers entspricht, und dass für die Maske vorzugsweise eine quadratische Linienstruktur (8) verwendet wird (Fig. 3a, b).

10. Vorrichtung nach einem der Ansprüche 7 bis 8, dadurch gekennzeichnet, dass die zeilenweise Integration der Helligkeitswerte analog über Operationsverstärker durchgeführt wird, ferner die Differenzbildung der aufeinanderfolgenden Integrale ebenfalls analog realisiert wird und dass dann die je Zeile vorliegenden Spannungswerte analog/digital gewandelt und in einer Recheneinheit, vorzugsweise in einem Mikroprozessor, gespeichert werden und dass dort die Flächen-schwerpunktsbestimmung, die Zusammenfas-sung mehrerer Flächenschwerpunkte zu Mittel-werten und daraus die Stellgrössen für den Justiervorgang ermittelt und ausgegeben werden.

11. Vorrichtung zur Durchführung des Verfahrens nach einem der Ansprüche 4 bis 6, dadurch gekennzeichnet, dass die Striche auf der Scheibe (17) und auf der Maske (16) ein zweidimensiona-les, quadratisches Gitter mit gleichen Abmessungen bilden und die Integrationsbereiche in parallelen Spalten kreuzweise über das Gitter angeordnet sind (Fig. 6).

## Claims

1. A method of positioning two objects which are to be aligned relative to one another, in particular for the automation of mask adjustment in order to precisely adjust the structure of a mask to the structure of a disc during the exposure of the disc to light in semiconductor production, characterised in that by using straight lines (9, 20) and (8, 18) which run mutually orthogonal on the disc (3, 17) and one the mask (16), row-by-row (7) opto-electronic scanning (12, 15) in parallel to said lines enables the intensity of the brightness values to be integrated row-wise or row-section-wise (fig. 2c, 5b) the values resulting therefrom stored, and the difference of the integration result of consecutive rows formed (fig. 2d, 2e, 5c), and that on the basis of the local curve of the difference values produced as a result of a change in brightness thus formed, centroids are formed in the zones beneath the difference value curves, and the positions of the various centroids obtained in this way are combined to form a first mean value which corresponds to the line boundary (fig. 2g, 5e) and the first mean values are possibly combined to form a second mean value which is to be assigned to the position of the central axis of a line on the disc and on the mask (fig. 5f), and that this process is carried out for both of the orthogonal directions (x, y) of the adjustment structures on the mask and on the disc.

2. A method as claimed in claim 1, characterised in that the method is carried out in at least two steps, these comprising a coarse adjustment and a fine adjustment, and that for coarse adjustment in the boundary zone of the field of vision (10) of the scanning device row-by-row integration is carried out in order to detect the lines on the disc, and that then the disc and the mask are moved, and for fine adjustment in another integration zone, e. g. in the centre of the field of vision of the scanning device, the relative position of adjustment lines of mask and disc which are now closely adjacent to one another is determined.

3. A method as claimed in claim 2, characterised in that in order to achieve a high degree of accuracy in the fine adjustment, the adjustment lines (9) of the disc are located between those (8) of the mask and vice versa, so that an observation of symmetry can be carried out (fig. 3a, b).

4. A method as claimed in claim 3, characterised in that the scanning is effected by a multiple arrangement of analogue, opto-electronic indi-vidual arrangements featuring parallel informa-tion processing, each of which detect analogue integration zones, where the observation of symmetry is always carried out within one individual arrangement and the individual rersults are combined to form a final result (fig. 6).

5. A method as claimed in claim 4, characterised in that each individual arrangement is assigned an integration zone, each of which contains one line · on the mask, on the disc, and again on the mask, or vice versa, where the integration direction runs parallel to the lines in question and the integration length corresponds to the length of the lines within the field of vision of the individual arrangement (fig. 6).

6. A method as claimed in claims 4 and 5, characterised in that as regards the mean value formation a weighting of the results is effected in such manner that the individual results from zones unlikely to involve measuring unreliability are assigned higher values, e. g. in the case of a two dimensional grid arrangement the centre which lies closest to the optical axis is assigned a higher weight than the results from the individual arrangements which are further removed from the optical axis (fig. 8).

7. A device for carrying out the method claimed in any one of the claims 1 to 3, characterised in that for each adjustment zone an optical unit with an illuminating device (23) is provided which focusses that zone of the mask (16) and the disc (17) which is provided with adjustment structures upon an image converter (12) which carries out row-by-row scanning.

8. A device as claimed in claim 7, characterised in that in order to achieve scanning directions which are mutually orthogonal two appropriately arranged television cameras (12) or solid body image converters are provided, or image converters (15) having a freely selectable scanning direction, such as for example an image dissection tube, or that the optical image is rotated by a corresponding arrangement (13) and is focussed on an image converter which possesses a fixed scanning direction.

9. A device as claimed in claim 7 or 8, characterised in that by way of adjustment structure on the disc preferably a cross (9) is used which can also consist of a plurality of lines, and whose length corresponds approximately to the field of vision of the image converter, and that preferably a square line structure (8) is used for the mask (fig. 3a, 3b).

10. A device as claimed in one of the claims 7 to 8, characterised in that the row-by-row integration of the brightness values is carried out in analogue fashion via operational amplifiers, and the difference formation of the consecutive integrals is likewise carried out in analogue form, and that then the voltage values which occur in respect of each row are analogue/digital converted and stored in a calculating unit, preferably a microprocessor, and that therein the centroid determination, the combination of a plurality of centroids to form mean values, and thus the control values for the adjustment process are determined and output.

11. A device for carrying out the method as claimed in one of the claims 4 to 6, characterised in that the lines on the disc (17) and on the mask (16) form a two-dimensional square grid of equal dimensions and the integration zones are arranged in parallel gaps crosswise across the grid (fig. 6).

**Revendications**

1. Procédé pour positionner deux objets à ajuster l'un sur l'autre, notamment pour l'automatisation de l'adjustage de masque, pour ajuster de façon précise la structure du masque par rapport à la structure sur la pastille lors de l'exposition de la pastille dans la fabrication de semiconducteurs, caractérisé par le fait que l'intensité de la luminosité est intégrée ligne par ligne ou section de ligne par section de ligne (fig. 2c, 5b) à l'aide de différents repères rectilignes s'étendant orthogonalement les uns par rapport aux autres (9, 20 ou 8, 18) sur la pastille (3, 17) ou sur le masque (16), au moyen d'un balayage optoélectronique (12, 15) ligne par ligne respectivement parallèlement à ces repères, que les valeurs qui en résultent sont mémorisées et qu'est formée la différence à partir du résultat d'intégration de lignes successives (fig. 2d, 2e, 5c), et qu'à partir de l'allure locale ainsi obtenue des valeurs de différences, qui proviennent de la variation de luminosité, sont formés des centres de gravité de surfaces dans les régions situées sous les courbes de différences, et que les positions ainsi obtenues des différents centres de gravité de surfaces sont en outre combinées pour former une première valeur moyenne qui correspond au bord du repère (fig. 2g, 5e) et éventuellement les premières valeurs moyennes sont combinées pour former une seconde valeur moyenne qui est associée à la position de l'axe central d'un repère sur la pastille ou le masque (fig. 5f), et que cette procédure est suivie pour les deux directions orthogonales (x, y) des structures d'ajustage sur le masque et la pastille.

2. Procédé suivant la revendication 1, caractérisé en ce que le procédé a lieu en ou moins deux phases distinctes, à savoir un ajustage grossier et un ajustage fin, et que pour l'ajustage grossier l'intégration ligne par ligne est effectuée dans la zone marginale du champ optique (10) du dispositif de balayage pour la détection des repères sur la pastille, et qu'ensuite on déplace la pastille ou le masque, et que pour l'ajustage fin on détermine la position relative du repère d'ajustage déjà très voisin du masque et de la pastille, dans une autre zone d'intégration, par exemple au milieu du champ optique du dispositif de balayage.

3. Procédé suivant la revendication 2, caractérisé en ce que pour obtenir une précision élevée lors de l'ajustage fin, des lignes d'ajustage (9) de la pastille se trouvent entre celles (8) du masque ou inversement, de sorte qu'on peut obtenir un raisonnement de symétrie (fig. 3a, 3b).

4. Procédé suivant la revendication 3, caractérisé par le fait que le balayage est effectué par un agencement multiple d'agencements individuels optoélectroniques analogiques avec traitement en parallèle des informations, qui couvre respectivement des zones d'intégration analogiques, le raisonnement de symétrie étant respectivement respectée à l'intérieur d'un agencement individuel, et les résultats individuels étant réunis pour former un résultat final (fig. 6).

5. Procédé suivant la revendication 4, caractérisé par le fait qu'à chaque agencement individuel est associée une zone d'intégration qui contient respectivement un repère sur le masque, sur la pastille, et de nouveau sur le masque ou inversement, la direction d'intégration étant parallèle aux repères respectifs, et la longueur d'intégration correspondant à la longueur des lignes à l'intérieur du champ optique du dispositif individuel (fig. 7).

6. Procédé suivant les revendications 4 et 5, caractérisé par le fait que lors de la formation de la valeur moyenne une pondération des résultats a lieu de manière qu'aux résultats individuels provenant de zones avec une insécurité de mesure prévue plus faible sont attribuées des valeurs plus élevées, par exemple dans le cas d'un agencement de réseaux bidimensionnels au milieu, qui se trouvent le plus proche de l'axe optique, est attribué un poids plus élevé qu'aux résultats provenant d'agencements individuels qui sont plus éloignés de l'axe optique (fig. 8).

7. Dispositif pour la mise en oeuvre du procédé suivant l'une des revendications 1 à 3, caractérisé par le fait que pour chaque zone d'ajustage est prévue une optique avec éclairage (23) qui forme l'image de la région du masque (16) et de la pastille (17), qui est munie des structures d'ajustage, sur un convertisseur d'image (12) effectuant un balayage ligné par ligne.

8. Dispositif suivant la revendication 7, caractérisé par le fait que pour obtenir des directions de balayage orthogonales l'une par rapport à l'autre, on prévoit deux caméras de télévision (12) ou des convertisseurs d'image à composants solides disposés de façon correspondante, ou qu'on utilise des convertisseurs d'image (15) avec une direction de balayage pouvant être choisie librement, comme par exemple un tube de dissection d'image, ou que l'image optique est tournée par un agencement correspondant (13) et est représentée sur un convertisseur d'image possédant une direction de balayage fixe.

9. Dispositif suivant l'une des revendications 7 ou 8, caractérisé par le fait que sur le disque comme structure d'ajustage on utilise de préférence une croix (9) qui peut également être constituée par plusieurs lignes et dont la longueur correspond sensiblement au champ optique du convertisseur d'image, et que pour le masque on utilise de préférence une structure de lignes carrée (8) (fig. 3a, 3b).

10. Dispositif suivant l'une des revendications 7 à 8, caractérisé par le fait que l'intégration ligne par ligne des luminosités est effectuée de façon analogique par l'intermédiaire d'amplificateurs opérationnels, qu'en outre la formation de différences des intégrales successives est également effectuée de façon analogique, et qu'ensuite les valeurs de tension existant pour chaque ligne sont converties de la forme analogique à la forme numérique et sont mémorisées dans une unité de calcul, de préférence dans un microprocesseur, et que là sont effectuées la détermination du centre de gravité de surface, la réunion de plusieurs centres de gravité de surfaces pour fournir des valeurs moyennes, et qu'à partir de cela les grandeurs de réglage pour le processus d'ajustage sont déterminées et délivrées.

11. Dispositif pour la mise en œuvre du procédé suivant l'une des revendications 4 à 6, caractérisé par le fait que les repères sur la pastille (17) et sur le masque (16) forment un réseau boidimensionnel carré de dimensions identiques, et que les zones d'intégration sont disposées en colonnes parallèles de façon croisée sur le réseau (fig. 6).

**FIG 1**

a

n
n+1
l
1

b

U
n
n+1
x

c

∫U
ΔU
x

**FIG 4e**

15
11
10
3

FIG 2

a

b

c

d

e

f

g

# FIG 3

FIG 4a

FIG 4c

FIG 4b

FIG 4d

FIG 5

FIG 5a

FIG 5b $\int U$

FIG 5c $\int U_n - \int U_{n-1}$

| S | M | S |

FIG 5d

FIG 5e

FIG 5f

FIG 5g

$\Delta x, \Delta y$

# FIG 6

# FIG 7

# FIG 8

| | | |
|---|---|---|
| Δy 11<br>Δx 11 | Δy 12<br>Δx 12 | Δy 13<br>Δx 13 |
| Δy 21<br>Δx 21 | Δy 22<br>Δx 22 | Δy 23<br>Δx 23 |
| Δy 31<br>Δx 31 | Δy 32<br>Δx 32 | Δy 33<br>Δx 33 |

| | | |
|---|---|---|
| 0,5 | 0,8 | 0,5 |
| 0,8 | 1 | 0,8 |
| 0,5 | 0,8 | 0,5 |

# FIG 9